# EUROPEAN PATENT SPECIFICATION

(11) **EP 1 876 652 B1**
(45) Date of publication and mention of the grant of the patent: **26.11.2008**
(21) Application number: 05747125.2
(22) Date of filing: 29.04.2005
(51) Int. Cl.: H01L 31/18, H01L 27/14

(54) **METHOD OF TREATING NON-REFRIGERATED, SPECTRALLY-SELECTIVE LEAD SELENIDE INFRARED DETECTORS**
VERFAHREN ZUM BEHANDELN VON UNGEKÜHLTEN, SPEKTRALSELEKTIVEN BLEISELENID-INFRAROTDETEKTOREN
PROCEDE DE TRAITEMENT DE DETECTEURS INFRAROUGE DE SELENIURE DE PLOMB NON REFRIGERES ET SPECTRALEMENT SELECTIFS

(43) Date of publication of application: 09.01.2008
(73) Proprietor: Ministerio De Defensa, 28071 Madrid (ES)
(72) Inventor: MONTOJO SUPERVIELLE, Marìa Teresa - C.I.D.A., 28033 MADRID (ES); RODROGUEZ FERNANDEZ, Purificaciòn - C.I.D.A., 28033 MADRID (ES); VERDÙ HERCÈ, Marina - C.I.D.A., 28033 MADRID (ES); GOMEZ ZAZO, Luis Jorge - C.I.D.A., 28033 MADRID (ES); ALMAZÀN CARNEROS, Rosa - C.I.D.A., 28033 MADRID (ES); VERGARA OGANDO, German - C.I.D.A., 28033 MADRID (ES)
(74) Representative: Sanchez del Campo Gonzalez de Ubierna, Ramon
(86) International application number: PCT/ES2005/000231
(87) International publication number: WO 2006/117413

(56) References cited:
- US-A- 4 996 579
- US-B2- 6 392 234
- TORQUEMADA M.C. ET AL.: 'Role of Halogens in the mechanism of sensitization of uncooled PbSe infrared photodetectors' JOURNAL OF APPLIED PHYSICS vol. 93, no. 3, 2003, pages 1778 - 1784, XP012058987
- A. MUNOZ ET AL: "PbSe photodetector arrays for IR sensors" THIN FILM SOLIDS, vol. 317, - 1998 pages 425-428,

## Description

### OBJECT OF THE INVENTION

It is a primary object of the present invention to provide a method to process multicolor polycrystalline lead selenide detectors based on substrate preparation, interference filters deposition and delineation followed of PbSe detectors processing on the interference filters. The method described is unique and clearly superior to others for processing uncooled multicolor IR infrared detectors. It is another object of this invention to provide a method to process improved single element polycrystalline lead selenide infrared detectors with the spectral selectivity feature monolithically integrated. It is yet another object of this invention to provide a method to process improved multielement polycrystalline lead selenide sensors with the spectral response of each detector modified as designed (multicolor sensor) and the spectral selectivity feature monolithically integrated. It is still another object of this invention to provide a method to process improved linear arrays of polycrystalline lead selenide with the spectral response of every/some detector/s modified as designed (multicolor sensor) and the spectral selectivity feature monolithically integrated. It is a further object of this invention to provide a method to process improved two dimensional arrays of polycrystalline lead selenide infrared detectors with the spectral response of every/some detector/s modified as designed (multicolor sensor) and the spectral selectivity feature monolithically integrated. It is still another object of this invention to provide a method to process improved x-y addressed two-dimensional arrays of polycrystalline lead selenide infrared detectors with the spectral response of every/some detector/s modified as designed (multicolor sensor) and the spectral selectivity feature monolithically integrated.

### FIELD OF THE INVENTION

The present invention relates to low cost uncooled infrared detectors, and in particular to a method to process spectrally selective polycrystalline lead selenide infrared detectors comprising substrate preparation, sequential multilayer interference filters deposition and delineation, PbSe deposition by thermal evaporation on corresponding interference filter, thermal treatment for sensitizing PbSe and detector pasivation. The method allows to process different type of uncooled and multicolor infrared detectors: single element, multi element, linear arrays and two-dimensional arrays, all of them with the spectral response of their sensors modified by an interference filter as designed.

### BACKGROUND OF THE INVENTION

Multicolour infrared (IR) detectors are very important to advanced IR sensor systems. An IR detector with multicolour capability presents multiple advantages compared to single band detectors. Spectral selectivity opens a wide variety of applications to the IR detectors. So, multicolour IR sensors are very useful in industry for gas leakage detection, chemical analysis environmental sensing and control, military missions etc. However, nowadays and due to fundamental and/or technological limitations the most of multicolour sensors are based in the technique of locating the IR detector on the focal plane of a wavelengths selector device (monochromator, interferometer, filters wheel etc.). There are few detectors with the spectral selectivity feature monolithically integrated. The most important technologies to enable multicolour IR detectors are Mercury Cadmium Telluride (CMT) and Quantum Well IR Photodetectors (QWIPs). Wavelength selection is brought about facts as change of composition, structure design, bias applied etc. Both detectors need to be cooled they are expensive and are sensitive to a number of colours or bands very limited by the technology.

M.C. Torquemada et al., Journal of Applied Physics, 93 ,1778-1784(2003) discusses the use of halogens to sensitive PbSE photodetectors. A. Munoz et al., Thin solid Films 317(1998), 425-428 describe photodetectors arrays of IR sensors.

Polycrystalline lead selenide is one of the oldest infrared detectors. It is a photonic detector, photoconductor type, sensitive to electromagnetic radiation of wavelengths up to 6 µm. Their most remarkable characteristics are: 1) it presents high detectivities at room temperature, 2) it is a fast detector (hundreds of kHz) 3) it is sensitive in the medium wave IR range (MWIR) and 4) it is cheap. The standard processing of polycrystalline lead selenide detectors is based on a chemical deposition process. During a long period of time this method has been considered as the most reliable method for processing polycrystalline lead selenide detectors, even though it presents important limitations: 1) it is compatible with a very limited number of substrates; 2) deposition of large polycrystalline clusters, makes necessary to use textured coatings which should have good adhesion properties with the substrate used, low thermal expansion coefficient mismatch with lead selenide, good electrical insulation, inertness to high pH chemicals, controllable finish etc.; 3) lack of film thickness uniformity and sensitivity across the substrate and from a substrate to other substrate.

Recently was filed a International Patent PCT about a new method for processing polycrystalline PbSe (PCT/ES 2004/000586). It is based on PbSe vacuum deposition followed of a specific sensitization process. It has been demonstrated that the new method is very versatile and compatible with different type of substrates, including CMOS circuitry (Complementary Metal-Oxide Semiconductor) to process monolithic devices. Based on the new polycrystalline PbSe technology and following a specific method of processing derived from that, it is possible to process polycrystalline PbSe IR detectors on interference filters. The technology developed allows to manufacture uncooled IR detectors with the spectral selectivity feature monolithically integrated.

### SUMMARY OF THE INVENTION

The method of the present invention comprises is as recited in claim 1. Further advantageous embodiments are recited in claims 2-9.

The substrate is preferably silicon but other suitable substrates, all of them have to be totally or partially transparent to the medium wavelength infrared radiation (MWIR), are sapphire, germanium etc. In case of using a semiconductor as substrate (Silicon, Germanium etc.) it is mandatory to diffuse or deposit a dielectric layer on its surface in order to prevent leaking currents and to guarantee good electrical isolation between detectors.

After substrate selection and surface preparation, the multilayer interference filters are deposited. It is a sequential process where the area corresponding to each filter are photolitographically selected. Depending on application and technical requirements, sometimes it is possible and recommended to design every filter with a common block of layers. It reduces the processing associated during the filter deposition stage.

Following filters processing, the metal layer for electrical contacts is deposited. Pure gold (99,99%) provides the best ohmic contacts with lead selenide. Depending on the type of substrate used and in order to improve gold adherence to the substrate, sometimes it is recommended to deposit between substrate and gold other conducting layers such as Cr, Ti, Ti-W etc. There is not any restriction but the last layer, the metal in direct contact with PbSe must be pure gold. After metal deposition, the next step is the delineation of contacts. It is possible to use several techniques (mechanical masks during metal deposition, photolithographic methods using suitable resins followed by dry or wet etching etc.). There is not any restriction with the delineation technique used while metal integrity (element purity, mechanical and electrical characteristics) would be kept unmodified. Hereinafter, the piece of material so processed is called patterned substrate (d-substrate).

Once d-substrate has been processed, next stage corresponds to PbSe deposition. A suitable photolithographic resin is spinned on d-substrate. The resin is insolated and developed in such a way that in those places designated for depositing PbSe, the resin is removed by dry or wet etching, leaving these places free of resin. After that a thin layer of PbSe is deposited by thermal evaporation in vacuum. Then, the resin and the PbSe deposited on it are removed by dry or wet etching, leaving the rest of PbSe directly bonded to the d-substrate. Hereinafter the piece of material so processed is called insensitive sensor (i-sensor)

In order to turn the i-sensor sensitive to infrared radiation, it is submitted to three consecutive thermal treatments. After that the polycrystalline PbSe detectors become sensitive to infrared light. Hereinafter the piece of material so processed will be called multicolor infrared sensor. Finally and with the objective to protect the whole sensor against environmental damages a thin layer of SiO is deposited on polycrystalline PbSe.

### BRIEF DESCRIPTION OF THE FIGURES

**FIGURE 1** shows a flowchart 100 illustrating one embodiment of the method to process multicolor polycrystalline lead selenide detectors.
**FIGURE 2A** shows a multicolor substrate (10) consisting in a piece of dielectric material (11) transparent to the IR infrared radiation of wavelengths shorter than 6 m such as sapphire, with a number n of interference filters deposited on its surface (12, 13, ....,n).
**FIGURE 2B** shows a multicolor substrate (20) consisting in a piece transparent in some range to the IR infrared radiation of wavelengths shorter than 6 microns comprising by a semiconductor (21) such as silicon, germanium etc. with a dielectric layer (22) deposited or diffused on at least one of their sides, on which are deposited a number n of interference filters (23, 24, ....,n).
**FIGURE 3A** shows the multicolor substrate described in figure 2A with metal contacts patterned and delineated on each interference filter (30).
**FIGURE 3B** shows the multicolor substrate described in figure 2B with metal contacts patterned and delineated on each interference filter (40).
**FIGURE 4** shows a multicolor substrate prepared and ready for depositing the PbSe (50).
**FIGURE 5** shows a multicolor substrate after PbSe deposition and resin removal by "lift off" (60).
**FIGURE 6** shows a multicolor array ready for being used (70). After the sensitization process the active material (71) is covered with a protecting and passivating layer of SiO (72).
**FIGURE 7** shows a diagram of a device (80) processed following the method described below. It comprises a sapphire substrate (81), an interference filter (82), contacts (83), polycrystalline PbSe sensitive to IR light (84) and a protecting coating (85).
**FIGURE 7A** shows the optical transmission curve of an interference filter processed following a standard method.
**FIGURE 7B** shows the spectral response of a standard PbSe detector processed following the method describe in this patent.
**FIGURE 7C** shows the spectral response of a PbSe detector processed following the method described in this patent. In this case, the response was measured illuminating the device with light impinging on the pasivation layer side.

### DETAILED DESCRIPTION OF THE INVENTION

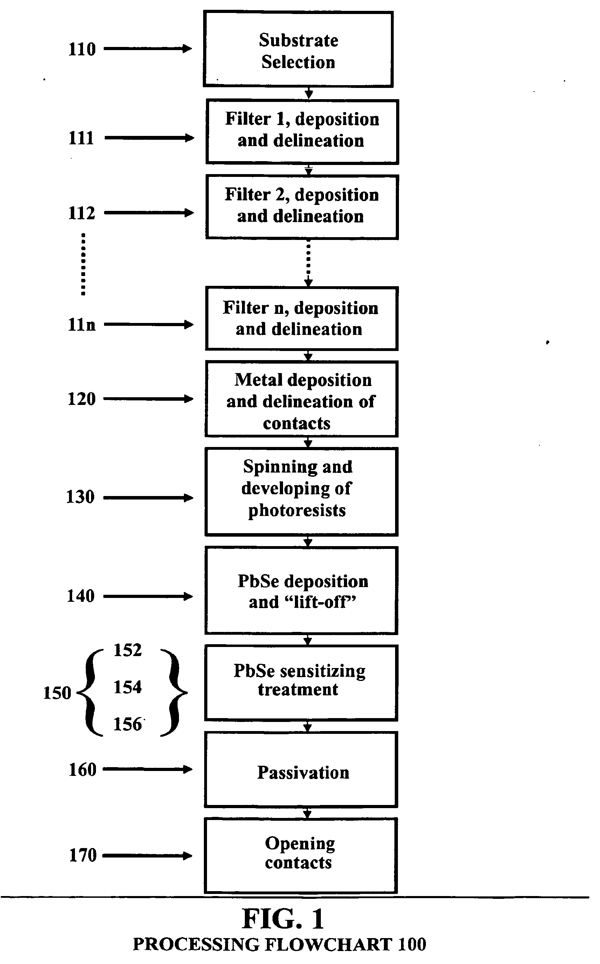

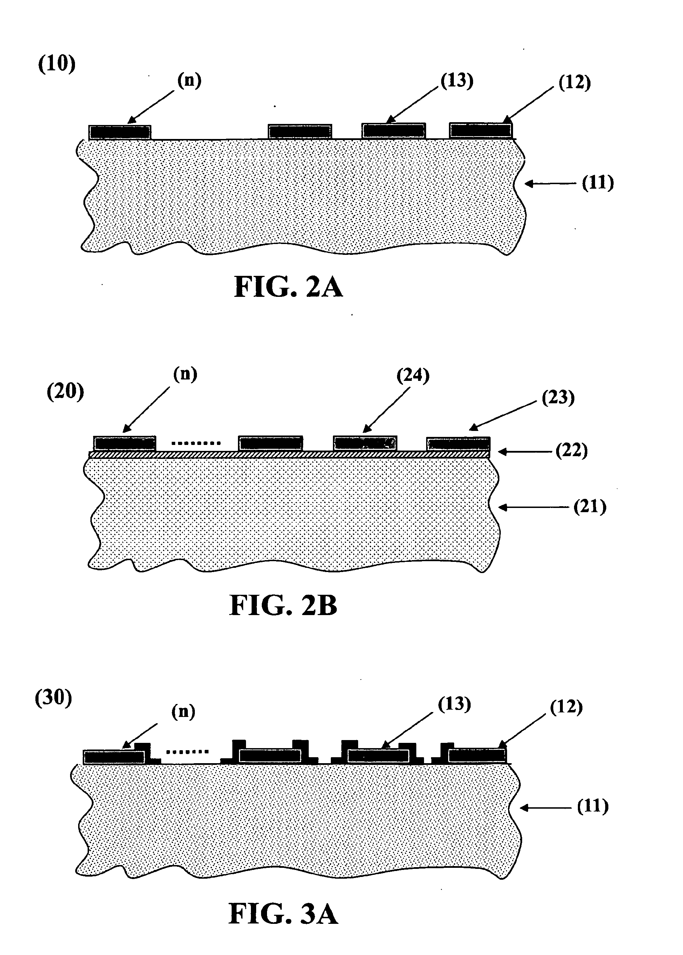

**FIGURE 1** shows a flowchart 100 illustrating one embodiment of the method to process multicolor polycrystalline lead selenide detectors. The method begins at step 110 by providing a suitable substrate; depending of the type of device to be processed the substrate material can be a dielectric material transparent to the medium wave infrared radiation (sapphire, ....) or a semiconductor material also transparent to the medium wave infrared radiation (silicon, germanium etc.). In this case it is necessary to diffuse or deposit a thin dielectric layer on their surface in order to avoid current leaks between sensors. The method continues at step 111 delineating and depositing layers corresponding to the first interference filter (color 1). Its delineation can be accomplished using mechanical masks or photolithography methods. Step 112 corresponds to delineation and deposition of second interference filter layers (color 2). Analogue to color 1 its delineation can be accomplished using mechanical masks or photolithography , methods... Step 11n corresponds to delineation and deposition of nth interference filter layers (color n). Analogue to the rest of colours its delineation can be accomplished using mechanical masks or photolithography methods. Hereinafter the substrate so processed will be called multicolor substrate. Figures 2A and 2B show a multicolour substrate. At this point it is important to considerer two facts. Last layer of every interference filter has to be a dielectric material and during filter design phase the thickness differences between different interference filters need to be minimized as possible.

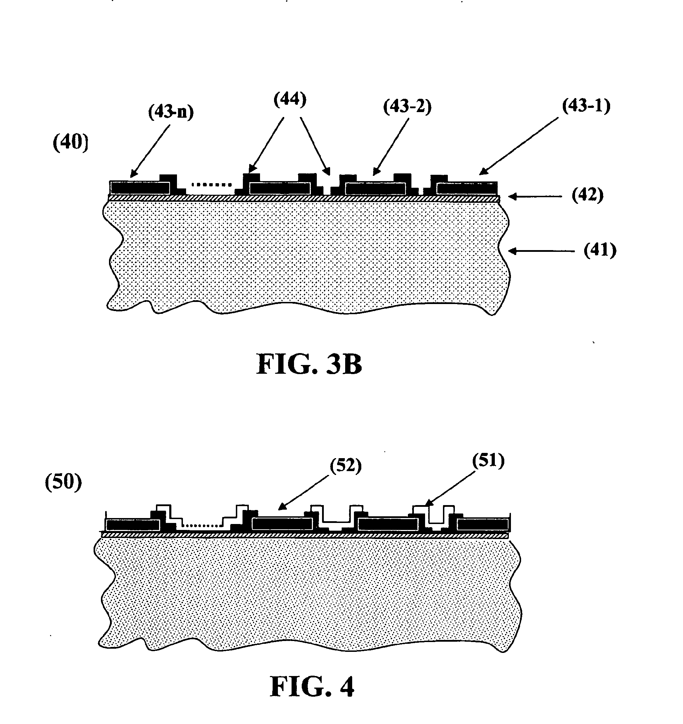

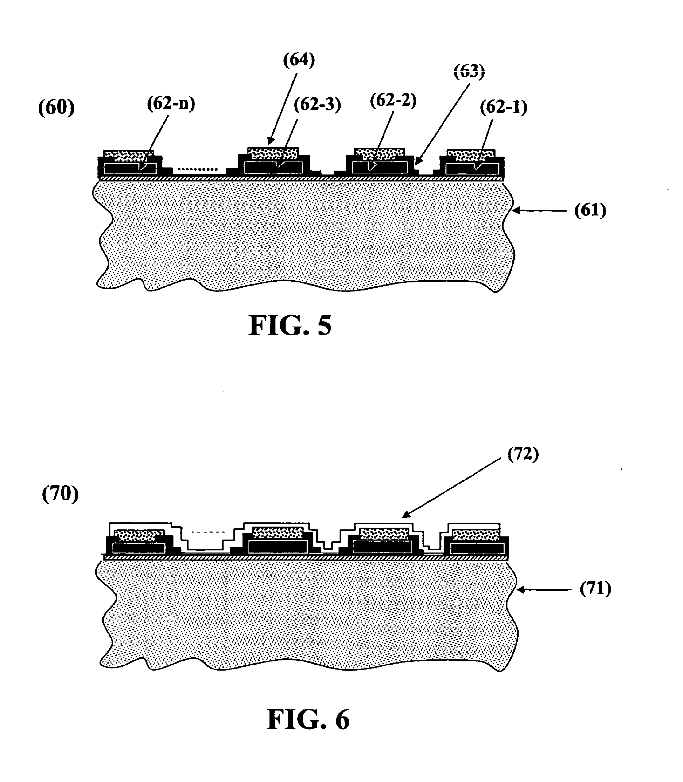

The method continues at step 120 depositing the metallic layers and delineating the contacts . Figures 3A and 3B show a piece of a multicolor substrate with the contacts delineated on it. Step 130 is described at Figure 4. Photolithography resin is spinned on multicolour substrate and removed in those places selected for depositing the sensible material. The method continues at step 140 depositing by thermal evaporation in vacuum a thin layer of PbSe 1-1,5 µm thick. After PbSe deposition the resin and the PbSe deposited on it are removed "lift off", leaving the substrate with well defined detectors onto its surface (Figure 5). The method continues at step 150 submitting the piece (multicolour substrate + detectors) to a sensitizing treatment. It consists in a three folded thermal treatment: at step 152 the piece is heating up to 290 °C under an atmosphere of oxygen+ iodine during 2 hours; after, at step 154, the piece is heating up to 450 °C in air during 6 hours; finally, at step 156 the piece is heating up to 240 °C under an atmosphere of oxygen during 90 minutes. The method continues at step 160 depositing a passivating layer of SiO on the detectors (figure 6). The method continues at step 170 opening external contacts via dry etching.

**FIGURE 2A** shows a multicolor substrate (10) consisting in a piece of dielectric material (11) transparent to the IR infrared radiation of wavelengths shorter than 6 m such as sapphire, with a number n of interference filters deposited on its surface (12, 13, ....,n). The n number and the geometrical disposition of the filters depends on requirements and, in principle, they are limited by the technology used for their processed (mechanical masks, photolithography etc). The multicolor substrate material (11) and the filters layers have to withstand temperatures as high as 450 °C maintaining unmodified all their electrical, mechanical, optical and functional characteristics. In order to avoid current leaks it is mandatory that the upper layer of the interference filters has to be a dielectric layer. Filter designers have to be in account this fundamental restriction.

**FIGURE 2B** shows a multicolor substrate (20) consisting in a piece transparent in some range to the IR infrared radiation of wavelengths shorter than 6 microns comprising by a semiconductor (21) such as silicon, germanium etc. with a dielectric layer (22) deposited or diffused on at least one of their sides, on which are deposited a number n of interference filters (23, 24, ....,n). The n number and the geometrical disposition of the filters depends on requirements and, in principle, they are limited by the technology used for their processed (mechanical masks, photolithography etc). The multicolor substrate material (21 and 22) and the interference filters have to withstand temperatures as high as 450 °C maintaining unmodified all their electrical, mechanical, optical and functional characteristics. In order to avoid current leaks it is mandatory that the upper layer of the interference filters has to be a dielectric layer. Filter designers have to be in account this fundamental restriction.

**FIGURE 3A** shows the multicolor substrate described in figure 2A with metal contacts patterned and delineated on each interference filter (30). This piece comprises of a dielectric (31) transparent to the infrared radiation. The interference filters deposited on this substrate (32-1, 32-2, ..., 32-n) with metal contacts (33) deposited and delineated, via photolithography, mechanical masks or another suitable method, on every interference filter. Pure gold (99,99%) provides the best ohmic contacts with lead selenide. Depending on the type of substrate used and in order to improve gold adherence to the filters, sometimes it is recommended to deposit between substrate and gold other conducting layers such as Cr, Ti, Ti-W etc. There is not any restriction but the last layer, the metal in direct contact with PbSe, must be pure gold. The substrate and the materials chosen as high dielectric constant and low dielectric constant layers constitutive of the interference filters have to withstand temperatures as high as 450 ° C maintaining all their electrical, mechanical, optical and functional characteristics.

**FIGURE 3B** shows the multicolor substrate described in figure 2B with metal contacts patterned and delineated on each interference filter (40). This piece comprises of a semiconductor (41) transparent to the infrared radiation with a thin dielectric layer diffused or deposited on its surface (42). Then interference filters deposited on this substrate (43-1, 43-2, ...43-n) with metal contacts (44) deposited and delineated, via photolithography, mechanical masks or another suitable method, on every interference filter. Pure gold (99,99%) provides the best ohmic contacts with lead selenide. Depending on the type of substrate used and in order to improve gold adherence to the filters, sometimes it is recommended to deposit between substrate and gold other conducting layers such as Cr, Ti, Ti-W etc. There is not any restriction but the last layer, the metal in direct contact with PbSe, must be pure gold. The substrate and the materials chosen as high dielectric constant and low dielectric constant layers constitutive of the interference filters have to withstand temperatures as high as 450 °C maintaining all their electrical, mechanical, optical and functional characteristics.

**FIGURE 4** shows a multicolor substrate prepared and ready for depositing the PbSe (50). A photosensitive resin (51) is spinned on the substrate described in figures 3A or 3B and then it is exposed to UV light and removed from those places where the PbSe has to be left (52). Anothers methods such as mechanical masks can be also used but photolithography is the most convenient way when small sizes are required.

**FIGURE 5** shows a multicolor substrate after PbSe deposition and resin removal "lift off' (60). PbSe deposition is made by thermal evaporation in vacuum. The starting material is powder of PbSe with a purity grade of 99,999 %. The layer deposited is typically 1-1.5 microns thick. During PbSe deposition, the substrate temperature must be constant, uniform and equal to 120° ± 1° C. During all deposition time oxygen must be introduced inside the vacuum chamber at a pressure of 1 x 10⁻⁴ mbar. Best results are obtained with deposition rates ranging between 6 and 8 Å/sg.

The piece comprises of substrate (61), interference filters (62-1, 62-2, ..., 62-n), contacts (63) and the active material, PbSe (64). As evaporated the PbSe is not sensitive to IR radiation. It is necessary to submit the piece to the three thermal treatment described in Figure 1, steps 152, 154 and 156.

**FIGURE 6** shows a multicolor array ready for being used (70). After the sensitization process the active material (71) is covered with a protecting and passivating layer of SiO (72).

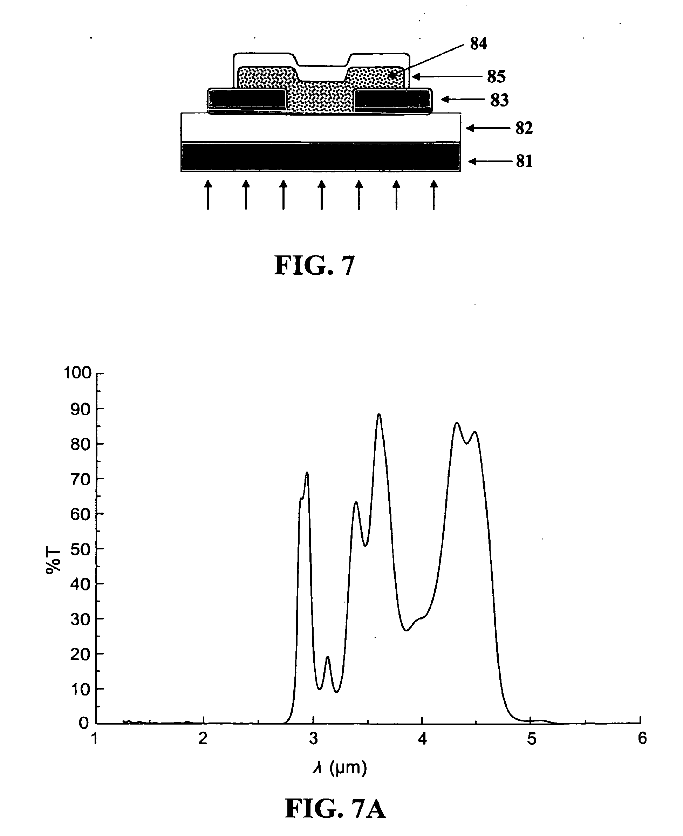

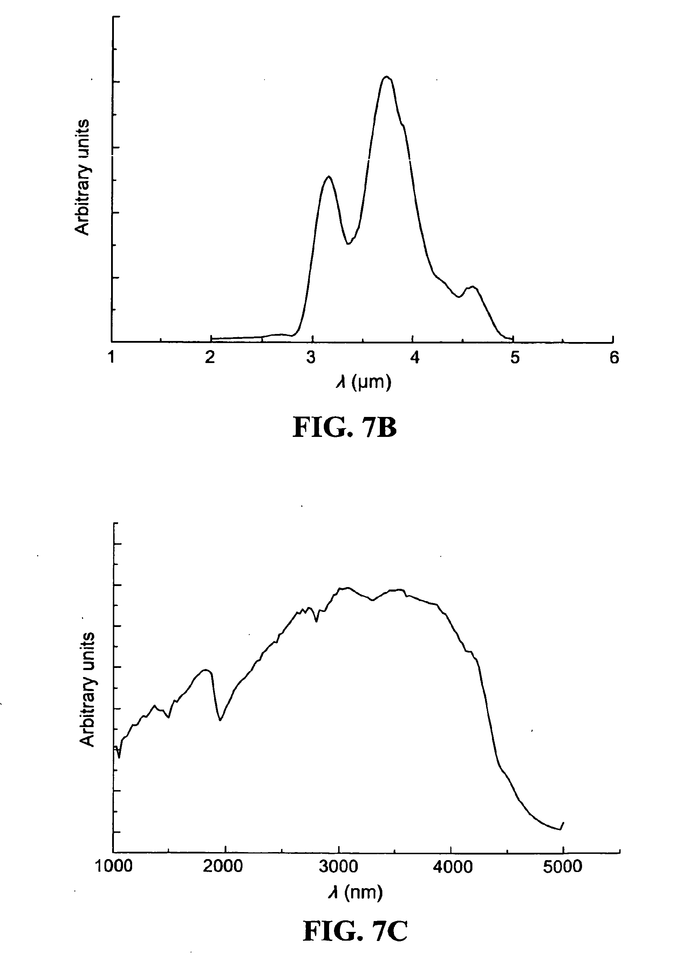

**FIGURE 7** shows a diagram of a device (80) processed following the method described below. It comprises a sapphire substrate (81), an interference filter (82), contacts (83), polycrystalline PbSe sensitive to IR light (84) and a protecting coating (85).

**FIGURE 7A** shows the optical transmission curve of an interference filter processed following a standard method. The filter consists of 56 sequentially deposited layers of Ge (high-n material) and SiO (low-n material). It is mandatory that the filter has to be finished with a good dielectric material. In this case, SiO.

**FIGURE 7B** shows the spectral response of a PbSe detector processed following the method described in this patent. The response was measured illuminating the device depicted in figure 7 with light coming from a monochromator impinging from the bottom side.

**FIGURE 7C** shows the spectral response of a standard PbSe detector processed following the method describe in this patent. In this case, the response was measured illuminating the device depicted in figure 7 with light coming from a monochromator impinging the detector from the upper side. It corresponds with the response of standard PbSe sensor measured at room temperature.

## Claims

1. A method to process spectrally selective uncooled lead selenide infrared detectors comprised of:
a. substrate selection and preparation and
b. interference filters design, delineation and deposition
c. metal contact delineation and deposition on every filter
d. sensor delineation and
e. PbSe deposition by thermal evaporation in vacuum and
f. PbSe sensitization consisting in a three-step thermal treatment of the PbSe :
- heating up to 290°C under an atmosphere of oxygen+ iodine during 2 hours;
- heating up to 450°C in air during 6 hours;
- heating up to 240°C under an atmosphere of oxygen during 90 minutes;
g. deposition of a passivating layer on the active material
h. contact opening

2. The method of claim 1, wherein the substrate comprises dielectric materials such as sapphire, glass with the restrictions of they have to be partially or totally transparent to IR radiation of wavelength shorter than 6 microns and have to withstand temperatures as high as 450°C maintaining all their electrical, mechanical, optical and functional characteristics.

3. The method of claim 1, wherein the substrate comprises, a semiconductor such as silicon, germanium, with a dielectric layer diffused or deposited on its surface with the restrictions of they have to be partially or totally transparent to the IR radiation of wavelength shorter than 6 microns and have to withstand temperatures as high as 450°C maintaining all their electrical, mechanical, optical and functional characteristics.

4. The method of claim 1, wherein the substrate is silicon with a thin layer of SiO₂ diffused on at least one side.

5. The method of claim 1, wherein the substrate is sapphire or other suitable dielectric material.

6. The method of claim 1, wherein the filters comprising a number n of thin layers sequentially deposited with different refraction index. The total number of layers and their compositions are a question of technological skills and limitations but always having in account that they have to withstand temperatures as high as 450°C maintaining all their electrical, mechanical, optical and functional characteristics and the upper layer of the filter has to be a good dielectric.

7. The method of claim 1, where the filter layers are SiO as low n material and Ge as high n material.

8. The method of claim 1, where contacts comprises of a single layer of gold or a multilayer of conductive materials with the upper layer of gold.

9. The method of claim 1, where the contact comprises three layers (from bottom to top) Cr/Ti-W/Au.

## Patentansprüche

1. Ein Verfahren zur Herstellung von spektralselektiven ungekühlten Infrarotdetektoren aus Bleiselenid, bestehend aus:
a) Substratauswahl und Zubereitung und
b) Interferenzfilterdesign, Entwurf und Aufbringen
c) Metallkontakt Entwurf und Aufbringen auf jeden Filter
d) Sensor Entwurf
e) Aufbringen des Bleiselenid durch Wärmeverdampfung im Vakuum und
f) Bleiselenid-Sensibilisierung, bestehend in einer Wärmebehandlung des Bleiselenids in drei Schritten:
- Erwärmung auf 290° C in einer Atmosphäre aus Sauerstoff und Jod für die Dauer von zwei Stunden;
- Erwärmung auf 450° C in Luft für die Dauer von sechs Stunden;
- Erwärmung auf 240° C in einer Atmosphäre aus Sauerstoff für die Dauer von 90 Minuten;
g) Aufbringen einer passivierenden Schicht auf die wirksame Masse
h) Kontaktöffnung

2. Das Verfahren nach Anspruch 1, wobei das Substrat dielektrische Materialien wie zum Beispiel Saphir oder Glas enthält, mit der Einschränkung, dass sie für Infrarotstrahlung mit einer Wellenlänge von weniger als sechs Mikrometer teilweise oder vollständig transparent sind und Widerstandstemperaturen von bis zu 450° C aufweisen, wobei sie all ihre elektrischen, mechanischen, optischen und funktionalen Eigenschaften aufrechterhalten.

3. Das Verfahren nach Anspruch 1, wobei das Substrat einen Halbleiter wie zum Beispiel Silizium oder Germanium enthält, mit einer dielektrischen Schicht, die auf dessen Oberfläche diffundiert oder aufgebracht ist, mit der Einschränkung, dass sie für Infrarotstrahlung mit einer Wellenlänge von weniger als sechs Mikrometer teilweise oder vollständig transparent sind und Widerstandstemperaturen von bis zu 450° C aufweisen, wobei sie all ihre elektrischen, mechanischen, optischen und funktionalen Eigenschaften aufrechterhalten.

4. Das Verfahren nach Anspruch 1, wobei das Substrat Silizium ist, mit einer dünnen Schicht SiO₂, welches mindestens auf einer Seite diffundiert ist.

5. Das Verfahren nach Anspruch 1, wobei das Substrat Saphir oder ein anderes geeignetes dielektrisches Material ist.

6. Das Verfahren nach Anspruch 1, wobei die Filter eine Anzahl n von dünnen Schichten umfassen, welche mit unterschiedlichen Refraktionsindizes sequenziell aufgebracht sind. Die Gesamtzahl der Schichten und deren Zusammensetzungen sind eine Frage der technologischen Fähigkeiten und der Beschränkungen, wobei jedoch stets zu berücksichtigen ist, dass sie über Widerstandstemperaturen von bis zu 450° C verfügen müssen, wobei sie all ihre elektrischen, mechanischen, optischen und funktionalen Eigenschaften aufrechterhalten, und die obere Schicht des Filters muss ein gutes Dielektrikum sein.

7. Das Verfahren nach Anspruch 1, wobei die Filterschichten aus SiO als niedriges n-Material und Ge als hohes n-Material bestehen.

8. Das Verfahren nach Anspruch 1, wobei die Kontakte eine einzige Schicht aus Gold oder eine Multischicht aus leitfähigen Materialen mit der oberen Schicht aus Gold umfassen.

9. Das Verfahren nach Anspruch 1, wobei der Kontakt drei Schichten umfasst (vom unten nach oben) Cr/Ti-W/Au.

## Revendications

1. Un procédé pour traiter des détecteurs à infrarouge au séléniure de plomb non refroidi spectralement sélectifs, le procédé comprenant :
a. la sélection et la préparation du substrat et
b. la conception, la délinéation et le dépôt des filtres interférentiels
c. la délinéation des contacts métalliques et le dépôt sur chaque filtre
d. la délinéation des capteurs et
e. le dépôt du PbSe par évaporation thermique sous vide et
f. la sensibilisation du PbSe consistant en un traitement thermique en trois étapes du PbSe :
- chauffer jusqu'à 290°C dans une atmosphère d'oxygène + iode pendant 2 heures ;
- chauffer jusqu'à 450°C dans l'air pendant 6 heures ;
- chauffer jusqu'à 240°C dans une atmosphère d'oxygène pendant 90 minutes ;
g. le dépôt d'une couche de passivation sur la matière active
h. l'ouverture des contacts

2. Le procédé de la revendication 1, dans lequel le substrat comprend des matériaux diélectriques tels que le saphir, le verre avec les restrictions qu'ils doivent être partiellement ou totalement transparents à une radiation IR de longueur d'onde inférieure à 6 microns et qu'ils doivent supporter des températures allant jusqu'à 450°C en conservant toutes leurs caractéristiques électriques, mécaniques, optiques et fonctionnelles.

3. Le procédé de la revendication 1, dans lequel le substrat comprend un semi-conducteur tel que le silicium, le germanium, avec une couche diélectrique diffusée ou déposée sur sa surface, avec les restrictions qu'ils doivent être partiellement ou totalement transparents à une radiation IR de longueur d'onde inférieure à 6 microns et qu'ils doivent supporter des températures allant jusqu'à 450°C en conservant toutes leurs caractéristiques électriques, mécaniques, optiques et fonctionnelles.

4. Le procédé de la revendication 1, dans lequel le substrat est le silicium avec une fine couche de SiO₂ diffusé sur un côté au moins.

5. Le procédé de la revendication 1, dans lequel le substrat est le saphir ou un autre matériau diélectrique approprié.

6. Le procédé de la revendication 1, dans lequel les filtres sont constitués d'un nombre n de fines couches déposées séquentiellement avec différents indices de réfraction. Le nombre total de couches et leurs compositions sont une question de capacités et de limitations technologiques mais en tenant toujours compte du fait qu'elles doivent supporter des températures allant jusqu'à 450°C en conservant toutes leurs caractéristiques électriques, mécaniques, optiques et fonctionnelles et que la couche supérieure du filtre doit être un bon diélectrique.

7. Le procédé de la revendication 1, où les couches de filtre sont SiO en tant que matériau à bas n et Ge en tant que matériau à haut n.

8. Le procédé de la revendication 1, où le contact est constitué d'une unique couche d'or ou d'une multicouche de matériaux conducteurs où la couche supérieure est de l'or.

9. Le procédé de la revendication 1, où le contact est constitué de trois couches (de bas en haut) Cr/Ti-W/Au.
